(19) Europäisches Patentamt
European Patent Office
Office européen des brevets

(11) **EP 2 479 779 A1**

(12) **EUROPEAN PATENT APPLICATION**
published in accordance with Art. 153(4) EPC

(43) Date of publication:
**25.07.2012  Bulletin 2012/30**

(21) Application number: **10817236.2**

(22) Date of filing: **16.09.2010**

(51) Int Cl.:
*H01L 21/027* (2006.01)    *B29C 33/38* (2006.01)
*B29C 59/02* (2006.01)     *B32B 3/26* (2006.01)
*B32B 27/30* (2006.01)     *B29K 33/04* (2006.01)
*B32B 3/30* (2006.01)

(86) International application number:
**PCT/JP2010/066020**

(87) International publication number:
**WO 2011/034123 (24.03.2011 Gazette 2011/12)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority:  **16.09.2009  JP 2009213968**

(71) Applicant: **Bridgestone Corporation Tokyo 104-8340 (JP)**

(72) Inventors:
• **INAMIYA Takato**
  **Kodaira-Shi**
  **Tokyo 187-8531 (JP)**

• **HASHIMOTO Masashi**
  **Kodaira-Shi**
  **Tokyo 187-8531 (JP)**
• **KAIDA Eizou**
  **Kodaira-Shi**
  **Tokyo 187-8531 (JP)**

(74) Representative: **Lamb, Martin John Carstairs Marks & Clerk LLP 90 Long Acre London WC2E 9RA (GB)**

(54) **PHOTOCURABLE TRANSFER SHEET, AND METHOD FOR FORMING RECESSED AND PROJECTED PATTERN USING SAME**

(57)    The present invention is to provide a photo-curable transfer sheet suitable for the preparation of an intermediate stamper in a nanoimprint method, in which the mold release properties from a mold having a fine concave-convex pattern used in the preparation of the intermediate stamper and the mold release properties of a cured photo-curable resin that is a product having a fine concave-convex pattern transferred from the intermediate stamper are excellent, and the transfer property of the fine concave-convex pattern is good; and a method for forming a concave-convex pattern by using the above-mentioned photo-curable transfer sheet. The photo-curable transfer sheet 10 having a photo-curable transfer layer 11 comprising a photo-curable composition deformable by application of pressure which comprises a polymer and a reactive diluent having a photopolymerizable functional group, wherein the polymer is an acrylic resin comprising a recurring unit derived from (meth)acrylate having an alicyclic group.

Fig. 1

## Description

### Background of Invention

Field of the invention

The present invention relates to a photo-curable transfer sheet advantageously utilized in the preparation of electronic devices, optical elements or recording media, and a method for forming concave-convex pattern, particularly a nanoimprint method which belongs to a microfabrication technology.

Description of the Related Art

A microfabrication technology using a light or an electron beam, which is outstandingly developed, enables processing (fabrication) into dimension of approx.100nm by using a light and processing into dimension of approx.10nm by using an electron beam. However, microfabrication devices are expensive, and hence an inexpensive microfabrication technology is desired. To meet to this purpose, nanoimprint technology is establishing a process for forming a desired circuit pattern on silicon substrate. The nanoimprint technology corresponds to the microfabrication technology enabling the formation of a more fine structure compared with a conventional press technology. This technology has no limit with respect to resolution, and the resolution depends on the accuracy of a prepared mold (metallic mold). Hence, if the mold can be finely prepared, an extremely fine structure can be easily formed by using a cheap device compared with a conventional photolithography.

The nanoimprint technology is largely divided into two types depending on materials to be transferred. One of the nanoimprint technologies is a thermal nanoimprint technology which is carried out by heating material to be transferred, subjecting it to plastic deformation by using a mold, and then cooling it to form pattern. The other of the nanoimprint technologies is a photo-nanoimprint technology which is carried out by applying a photo-curable liquid resin onto a substrate at room temperature, pressing a transparent mold to the liquid resin, and exposing the liquid resin on the substrate to light to cure it. Particularly, in the photo-nanoimprint technology, it is possible to form a pattern at room temperature, and therefore there is little strain caused by heating based on the difference between coefficient of thermal expansions of the substrate and the mold, whereby an accurate pattern can be formed. Hence, the photo-nanoimprint technology receives much attention as a technology instead of lithography for semiconductor or the like.

Though a pattern molding can be cheaply carried out by the nanoimprint technology, a resin is apt to stick to an original mold (metallic mold) as a mother stamper. If the resin sticks to the original mold, it will be extremely difficult to repair the resin-sticking mold. The mold is highly expensive, and therefore the nanoimprint technology necessarily is not cheap from the viewpoint of the whole production cost.

Patent Document 1 discloses an imprint method comprising two steps. In more detail, in a first step, a foil of plastic polymer such as thermoplastic polymer is placed on a template (the above mother stamper) having a surface on which a fine concave-convex pattern of micrometer or nanometer order size is formed, such that the surface of the foil is in contact with the surface of the template, and a pattern that the pattern of the template is inverted is formed on the surface of the polymer foil by imprint processing. Subsequently, in a second step, the pattern on the surface of the resultant polymer stamper (intermediate stamper) is processed by the same imprint processing as above to form a second inversed pattern (the same as the template) on another plastic polymer foil.

In this method, a product is obtained by molding (shape forming) using the intermediate stamper, and therefore the mother stamper (template) receives no serious damage. However, since a thermoplastic polymer is used for the preparation of the intermediate stamper, a large amount of energy and a long time period of one or more minute are required to heat and cool the polymer in the molding though a wide variety of polymers can be used. Thus it is difficult to reduce takt time (time period for processing) in the continuous production.

Further, Patent Document 1 also describes an example using a photo-curable resin together with the polymer in the preparation of the intermediate stamper. However, the photo-curable resin is in the form of liquid, and therefore its use brings about poor workability and increases of cure shrinkage and unevenness of thickness, whereby the enhanced productivity such as reduction of takt time cannot be ensured. Moreover, there are disadvantages that the peeling properties from the mother stamper and the peeling properties of the cured photo-curable resin are insufficient, the cured photo-curable resin corresponding to the product having a fine concave-convex pattern transferred from the intermediate stamper.

Patent Document 2 discloses a method for forming an intermediate stamper by using a photo-curable transfer sheet having a photo-curable composition deformable by application of pressure, which enables improvement of workability and cure shrinkage. Further the photo-curable composition of Patent Document 2 contains a phosphorus atom-containing compound as lubricant, whereby the peeling properties (mold release properties) from the mother stamper are improved.

Prior Patent Documents

Patent Documents

Patent Document 1: JP2007-165812 A
Patent Document 2: JP2007-291339 A

Brief Summary of the Invention

Problem to be solved by the invention

However, in case the imprint method comprising two steps is carried out by using the photo-curable transfer sheet of Patent Document 2, a first step of preparing an intermediate stamper from a mother stamper by an imprint method shows good molding properties and mold release properties but the second step of transferring the intermediate stamper to a photo-curable resin layer (especially radical-curable liquid UV-curable resin layer) occasionally has disadvantages that the photo-curable resin sticks to the intermediate stamper and that molding of a concave-convex pattern cannot be sufficiently exactly carried out.

Thus, an object of the present invention is to provide a photo-curable transfer sheet suitable for the preparation of an intermediate stamper in a nanoimprint method, in which the mold release properties from a mold having a fine concave-convex pattern used in the preparation of the intermediate stamper and the mold release properties of a cured photo-curable resin layer corresponding to a product having a fine concave-convex pattern transferred from the intermediate stamper are good, and the transfer property of the concave-convex pattern is excellent.

Further, an object of the present invention is to provide a method for forming a concave-convex pattern by using the above-mentioned photo-curable transfer sheet.

Means for Solving Problem

The above-mentioned object can be attained by a photo-curable transfer sheet having a photo-curable transfer layer composed of a photo-curable composition deformable by application of pressure which comprises a polymer and a reactive diluent having a photopolymerizable functional group,
wherein the polymer is an acrylic resin comprising a recurring unit derived from (meth)acrylate having an alicyclic group.

Thereby, the photo-curable transfer sheet shows excellent mold release properties from the mold or the photo-curable resin layer, especially excellent mold release properties from the photo-curable resin layer (especially radical-curable liquid UV-curable resin). This is because the photo-curable transfer layer contains a polymer having an alicyclic skeleton that shows low polarity.

The preferred embodiments of the photo-curable transfer sheet according to the present invention are as follows:

(1) The recurring unit of (meth)acrylate having an alicyclic group is a recurring unit derived from (meth)acrylate having an isobornyl group and/or a cyclohexyl group.
(2) The recurring unit of (meth)acrylate having an alicyclic group is contained in 32 to 44% by weight based on dry mass of photo-curable composition.
(3) The reactive diluent comprises a monomer having an alicyclic group.
(4) The monomer having an alicyclic group is a monomer having a dimethyloltricyclodecane group or an isobornyl group.

Further, the above-mentioned object can be also attained by a method for forming a concave-convex pattern comprising of the steps (1) to (3):

a step (1) of placing a mold having a fine concave-convex pattern surface thereon on the photo-curable transfer layer of the photo-curable transfer sheet as defined in any of claims 1 to 5, such that the concave-convex pattern surface of the mold is in contact with a surface of the photo-curable transfer layer, and depressing the mold and the photo-curable transfer sheet to form a laminate in which one surface of the photo-curable transfer layer adheres closely to the concave-convex pattern surface;
a step (2) of exposing the photo-curable transfer layer of the laminate having the mold to ultraviolet rays to cure the photo-curable transfer layer, and
a step (3) of removing the mold from the laminate to form an inverted pattern of the fine concave-convex pattern on a surface of the photo-curable transfer layer.

In the method, the photo-curable transfer sheet of the present invention is used for the transfer of a fine concave-convex pattern of the mold, and hence the photo-curable transfer sheet shows excellent mold release properties from the mold and a part of the transfer layer does not stick to the mold, whereby an inverted concave-convex pattern free from defect can be formed on the transfer layer.

Furthermore, the above-mentioned object can be also attained by a method for forming a concave-convex pattern comprising of the steps (4) to (6):

a step (4) of placing the photo-curable transfer sheet having the inverted pattern of the fine concave-convex pattern obtained by the method as defined in claim 6, which is referred to as an intermediate stamper, on a photo-curable resin layer consisting of a photo-curable resin composition layer formed on a substrate, such that the inverted concave-convex pattern surface of the intermediate stamper is in contact with a surface of the photo-curable resin layer and depressing the intermediate stamper and the photo-curable resin layer having the substrate to form a laminate in which the surface of the photo-curable resin layer adheres closely to the inverted concave-convex pattern surface; and

a step (5) of exposing the photo-curable resin layer of the laminate having the intermediate stamper to ultraviolet rays to cure the photo-curable resin layer, and

a step (6) of removing the intermediate stamper from the laminate to form a fine concave-convex pattern on a surface of the photo-curable resin layer, the fine concave-convex pattern being the same as that of the mold.

In the method, the photo-curable transfer sheet of the present invention having the inverted pattern of the fine concave-convex pattern is used as an intermediate stamper, and the (inverted) fine concave-convex pattern is transferred to the photo-curable resin layer formed on a substrate, whereby the intermediate stamper shows excellent mold release properties from the cured photo-curable resin layer, and therefore a part of the cured photo-curable resin layer does not stick to the intermediate stamper, hence bringing about an concave-convex pattern free from defect which is the same as that of the mold.

The preferred embodiments of the method for forming a concave-convex pattern according to the present invention are as follows:

(1) The photo-curable resin composition is in the form of liquid. In the method of the present invention, even the liquid photo-curable resin composition shows excellent mold release properties.

(2) The mold is a stamper. The method of the invention is effective for the formation of a fine concave-convex pattern by employing a stamper used in a nanoimprint method.

Effect of the invention

The photo-curable transfer sheet of the present invention has a photo-curable transfer layer containing a polymer having an alicyclic skeleton that shows low polarity. Therefore, the photo-curable transfer sheet shows excellent mold release properties from the stamper or the photo-curable resin layer, especially excellent mold release properties from the photo-curable resin layer (especially radical-curable liquid UV-curable resin layer), and simultaneously excellent transfer property of the concave-convex pattern. Further, the method for forming a fine concave-convex pattern of the present invention, which includes photo-nanoimprint method, uses the photo-curable transfer sheet of the present invention as the intermediate stamper, and hence the fine concave-convex pattern of the mold can be exactly transferred to the photo-curable resin layer corresponding to the product.

Thus, the use of the method for forming concave-convex pattern of the present invention advantageously enables the productions of electronic display ribs, electronic devices (lithography, transistor), optical elements (microlens array, waveguide, optical filter, photonic(s) crystal), bio-related materials (DNA tip, microreactor) and recording media (patterned media, DVD).

Brief Description of the Drawings

[Fig. 1]

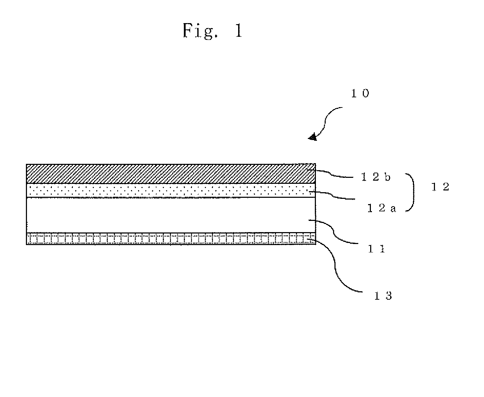

Fig. 1 is a schematic section view showing a representative example of the photo-curable transfer sheet of the present invention.
[Fig. 2]

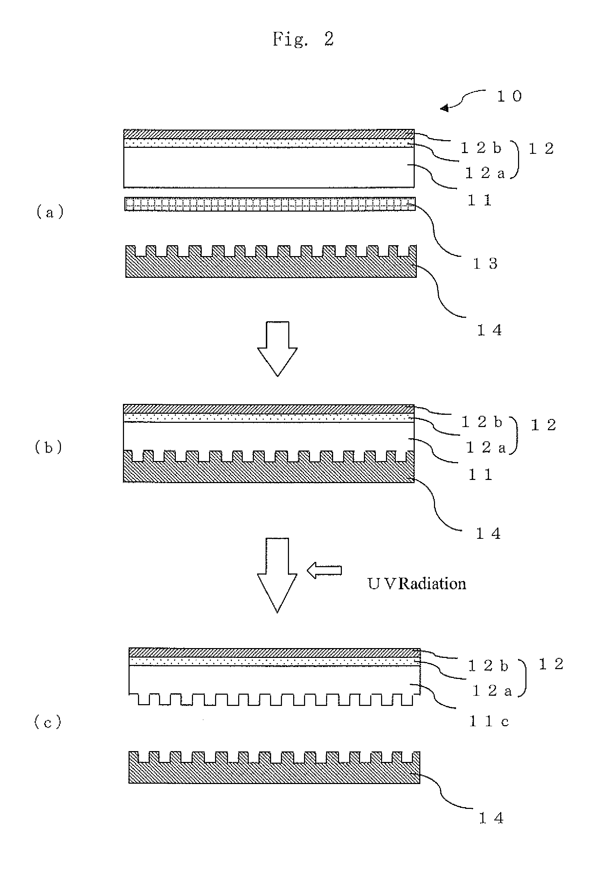

Fig. 2 is a schematic section view showing a representative example of a method for forming a fine concave-convex pattern of the present invention.

[Fig. 3]

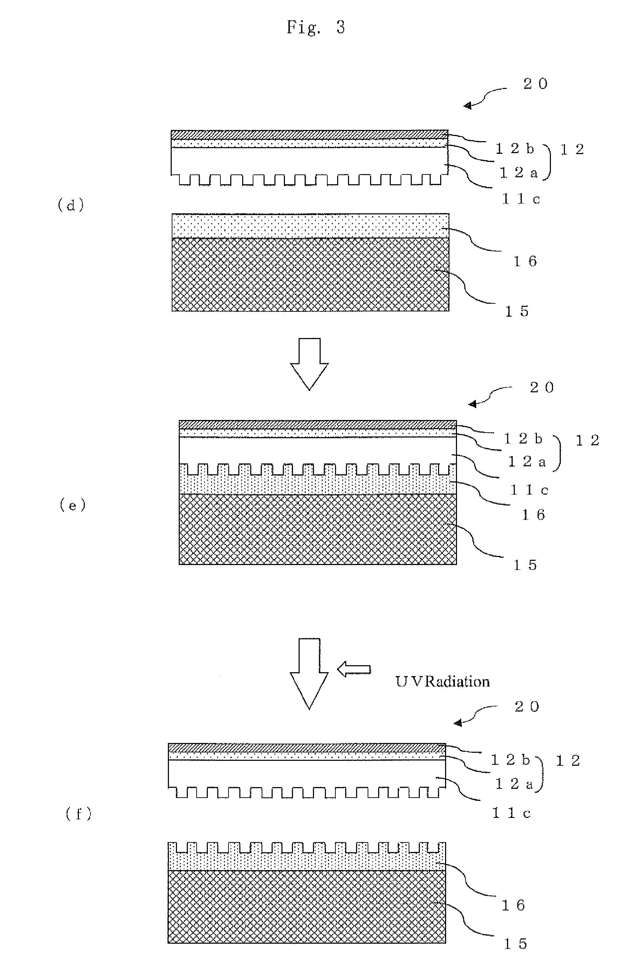

Fig. 3 is a schematic section view showing a representative example of a method for forming a fine concave-convex pattern of the present invention (in case of following the stages of Fig. 2).

[Fig. 4]

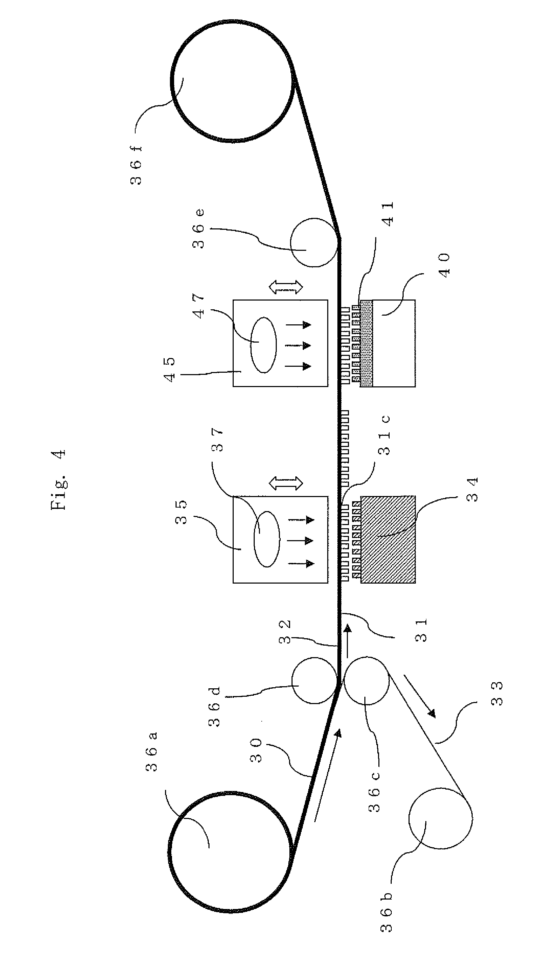

Fig. 4 is a schematic section view showing a representative example of a continuous method for forming a fine concave-convex pattern of the present invention.

Mode for Carrying out the Invention

Embodiments of the invention are explained in detail by referring to drawings.

Fig. 1 is a schematic section view showing a representative example of an embodiment of the photo-curable transfer sheet 10 of the present invention. A photo-curable transfer layer 11 has a transparent film 12 consisting of a polymer film 12b having an adhesion layer 12a, the transparent film 12 being provided on one side of the layer 11, and further has a release sheet 13 on the other side of the layer 11. The transparent film 12 strongly adheres to the photo-curable transfer layer 11 by the adhesion layer 12a. The adhesion layer 12a shows excellent adhesion properties to the photo-curable transfer layer 11 and the cured photo-curable transfer layer 11 as well as the polymer film 12b. The polymer film 12b gives film self-supporting characteristics to the photo-curable transfer sheet 10 and the cured photo-curable transfer sheet 10. The release sheet 13 is provided for protection of the photo-curable transfer layer. Though the release sheet 13 therefore is not provided, it is preferably provided in view of handling in the case of using a continuous sheet. The release sheet 13 generally consists of a plastic sheet and a release layer provided thereon, and the release layer is in contact with a surface of the photo-curable transfer layer 11. The release sheet 13 is generally removed when the sheet is used.

[Photo-curable transfer layer]

The photo-curable transfer layer 11 is configured to be easily deformable by application of pressure such that a fine concave-convex pattern of a mold (preferably stamper) can be precisely transferred to the layer by depressing the mold and the layer, and at the same time, to have excellent mold release properties (peeling properties) from the stamper after curing. Further, when the cured photo-curable transfer layer 11 is used as an intermediate stamper, it shows excellent mold release properties from a cured photo-curable resin layer as a product having the transferred fine concave-convex pattern. Furthermore, the cured photo-curable transfer layer 11 shows excellent transfer property to the cured photo-curable resin layer (especially radical-curable liquid UV-curable resin layer).

In the present invention, a photo-curable composition for forming the photo-curable transfer layer 11 is generally composed mainly of a polymer, a reactive diluent (generally monomer or oligomer) having a photo-polymerizable functional group (generally carbon-carbon double bond, preferably (meth)acryloyl group which means an acryloyl group or a methacryloyl group), a photopolymerization initiator, and if necessary other additives. The polymer is composed of acrylic resin comprising a recurring unit derived from (meth)acrylate having an alicyclic group. The (meth)acryloyl group means an acryloyl group or a methacryloyl group as mentioned above. An alicyclic skeleton made up of the recurring unit derived from (meth)acrylate having an alicyclic group shows low polarity, and therefore the photo-curable transfer layer of the invention shows excellent mold release properties from the mold or the photo-curable resin layer, especially excellent mold release properties from the photo-curable resin layer.

The alicyclic group of the invention preferably includes an alicyclic hydrocarbon group, and an alicyclic ether group. The alicyclic group preferably has 3 to 12 carbon atoms. Examples of the alicyclic hydrocarbon group include an isobornyl group, a cyclohexyl group, a norbornyl group, a cyclodecyl group, a cyclopentyl group, a menthyl group, a fenchyl group, an adamantyl group. Examples of the alicyclic ether group include a tetrahydrofurfuryl group, a tetrahydropyran-2-methyl group, a 2-ehtyl-3-oxetanemethyl group. Thereby, further an alicyclic skeleton having lower polarity can be obtained. From the viewpoint of excellent mold release properties of the photo-curable resin layer, preferred is the alicyclic hydrocarbon group. Particularly, preferred are an isobornyl group and a cyclohexyl group.

Although the content rate of the recurring unit of (meth)acrylate having an alicyclic group is not particularly restricted, too low content rate brings about reduction of mold release properties whereas too high content rate leads to reduction of transfer property or workability. Hence, the content rate of the recurring unit of (meth)acrylate having an alicyclic group preferably is in the range of 32 to 44% by weight, especially 37 to 43% by weight, based on dry mass of photo-curable composition.

The content rate of the recurring unit of (meth)acrylate having an alicyclic group in the photo-polymerizable composition is also referred to as "alicyclic group containing monomer unit content rate T". The content rate T can be calculated as below.

(1) The content rate of the recurring unit of (meth)acrylate having an alicyclic group in the polymer of the photo-curable composition is also referred to as "alicyclic group containing monomer unit content rate P". The content rate P can be calculated by the following formula (I) using "weight of alicyclic group containing monomer" and "total weight of all monomers", these monomers having been used for the preparation of the polymer of the photo-curable composition.

$$\text{``alicyclic group containing monomer unit content rate P''} =$$
$$(\text{``weight of alicyclic group containing monomer''} / \text{``total weight of all monomers''}) \times 100(\%) \quad \cdots\cdots\cdots (I)$$

(2) The above-mentioned "alicyclic group containing monomer unit content rate T" can be calculated by the following formula (II) using "alicyclic group containing monomer unit content rate P", "weight of alicyclic group containing polymer" and "total weight of photo-curable composition", the alicyclic group containing polymer having been used for the preparation of the photo-curable composition.

$$\text{``alicyclic group containing monomer unit content rate T''} =$$
$$(((\text{``alicyclic group containing monomer unit content rate P''}/100) \times \text{``weight of alicyclic group containing polymer''}) / \text{``total weight of photo-curable composition''}) \times 100(\%) \quad \cdots\cdots\cdots (II)$$

[Polymer]

The photo-curable composition for forming the photo-curable transfer layer 11 preferably comprises a polymer having glass transition temperature (Tg) of not less than 80°C, whereby the fine concave-convex pattern of the mold can be easily transferred and the curing can be carried out in high speed. Further the cured shape can be also maintained without variation of the shape for a long time period because of the high Tg. The polymer having glass transition temperature (Tg) of not less than 80°C preferably has a polymerizable functional group because it can be reacted with the reactive diluent to enhance the curing rate. The polymer preferably has hydroxyl group because the transfer layer can be a little cured by use of diisocyanate, whereby exudation of the integrants of the layer and variation of the thickness are greatly suppressed. The use of the diisocyanate is effective to some extent even if the polymer has no hydroxy group.

Hence, an acrylic resin constituting the polymer of the photo-curable composition of the invention particularly preferably is an acrylic resin having a polymerizable functional group or a hydroxyl group.

The acrylic resin having a polymerizable functional group of the invention generally is a copolymer derived from at least one of (meth)acrylate (which means methacrylate or acrylate, and so forth) having an alicyclic group as mentioned above and glycidyl (meth)acrylate as monomer components, the glycidyl group of the glycidyl (meth)acrylate being reacted with carboxylic acid having a polymerizable functional group; or a copolymer derived from at least one of (meth)acrylate having an alicyclic group as mentioned above and carboxylic acid having a polymerizable functional group as monomer components, the carboxyl group of the carboxylic acid having a polymerizable functional group being reacted with glycidyl (meth)acrylate.

The (meth)acrylate having an alicyclic group preferably is (meth)acrylate having an alicyclic group having 3 to 12 carbon atoms. Examples of the (meth)acrylate having an alicyclic group having 3 to 12 carbon atoms include isobornyl (meth)acrylate, cyclohexyl (meth)acrylate, norbornyl (meth)acrylate, cyclodecyl (meth)acrylate, cyclopentyl (meth)acrylate, menthyl (meth)acrylate, fenchyl (meth)acrylate, adamantyl (meth)acrylate, tetrahydrofurfuryl (meth)acrylate, tetrahydropyrane-2-methyl (meth)acrylate, and 3-ethyl-3-oxetanemethyl (meth)acrylate. The (meth)acrylate having an alicyclic group preferably is (meth)acrylate having alicyclic hydrocarbon group such as isobornyl (meth)acrylate, cyclohexyl (meth)acrylate, cyclodecyl (meth)acrylate. Especially, isobornyl (meth)acrylate and cyclohexyl (meth)acrylate are preferred because they brings about a photo-curable transfer layer having excellent mold release properties and transfer property.

Although the content rate of a recurring unit of (meth)acrylate having an alicyclic group in the polymer is not restricted, the content rate preferably is in the range of 50 to 100% by weight, especially 60 to 90% by weight. Since the content rate of the recurring unit of (meth)acrylate having an alicyclic group based on all the photo-curable composition have an influence on the mold release properties of the photo-curable transfer layer, the content rate of the recurring unit of (meth)acrylate having an alicyclic group is preferably adjusted in the step for preparing this polymer.

Further, the glycidyl (meth)acrylate or the carboxylic acid having a polymerizable functional group is generally contained in an amount of 5 to 25% by weight, preferably 5 to 20% by weight in the polymer. The resultant copolymer having glycidyl (meth)acrylate is reacted with carboxylic acid having a polymerizable functional group, while the resultant copolymer having carboxylic acid having a polymerizable functional group reacted with glycidyl (meth)acrylate.

The acrylic resin of the invention may have as other monomers methyl methacrylate and/or alkyl (meth)acrylate whose alkyl has 2 to 10 carbon atoms. Examples of the alkyl (meth)acrylate whose alkyl has 2 to 10 carbon atoms (especially 3 to 5 carbon atoms) include ethyl (meth)acrylate, n-propyl (meth)acrylate, isopropyl (meth)acrylate, n-butyl (meth)acrylate, isobutyl (meth)acrylate, 2-ethylhexyl (meth)acrylate. The other monomers preferably include methyl methacrylate, n-butyl (meth)acrylate, isobutyl (meth)acrylate, 2-ethylhexyl (meth)acrylate, especially methyl methacrylate.

The acrylic resin having a polymerizable functional group is, for example, prepared as follows:

One or plural (meth)acrylate(s) (comprising at least one (meth)acrylate having an alicyclic group as mentioned above) is reacted with a compound having a glycidyl group and a photopolymerizable functional group (preferably glycidyl (meth)acrylate), or with a carboxylic acid having a photopolymerizable functional group in the presence of a radical polymerization initiator and an organic solvent according to a known polymerization process such as a solution polymerization process, whereby glycidyl group-containing acrylic resin (a) or carboxyl group-containing acrylic resin (b) is obtained.

Subsequently, carboxylic acid having a photopolymerizable functional group is added to the glycidyl group-containing acrylic resin (a), or a compound having a glycidyl group and a photopolymerizable functional group (preferably glycidyl (meth)acrylate) is added to the carboxyl group-containing acrylic resin (b), with if necessary heating to prepare an acrylic photo-curable resin (A) or an acrylic photo-curable resin (B). A molar ratio of carboxyl group to glycidyl group is generally 1/0.9 to 1/1, preferably 1/1. Excess glycidyl group may bring about disadvantages in long-term stability such as increase of viscosity or gelation, whereas excess carboxyl group reduces workability due to increase of skin irritation. Further, the ratio of 1/1 brings about disappearance of glycidyl group to extremely enhance storage stability. The reaction can be carried out according to known methods in the presence of basic catalyst or phosphorous catalyst.

The acrylic resin having a hydroxyl group of the invention generally is a copolymer derived from at least one of (meth)acrylate having an alicyclic group as mentioned above and hydroxyalkyl (meth)acrylate whose hydroxyalkyl has 2 to 4 carbon atoms.

The (meth)acrylate having an alicyclic group preferably is (meth)acrylate having an alicyclic group having 3 to 12 carbon atoms. Examples of the (meth)acrylate having an alicyclic group having 3 to 12 carbon atoms include isobornyl (meth)acrylate, cyclohexyl (meth)acrylate, norbornyl (meth)acrylate, cyclodecyl (meth)acrylate, cyclopentyl (meth)acrylate, menthyl (meth)acrylate, fenchyl (meth)acrylate, adamantyl (meth)acrylate, tetrahydrofurfuryl (meth)acrylate, tetrahydropyrane-2-methyl (meth)acrylate, and 3-ethyl-3-oxetanemethyl (meth)acrylate. The (meth)acrylate having an alicyclic group preferably is (meth)acrylate having alicyclic hydrocarbon group such as isobornyl (meth)acrylate, cyclohexyl (meth)acrylate, cyclodecyl (meth)acrylate. Especially, isobornyl (meth)acrylate and cyclohexyl (meth)acrylate are preferred because they brings about a photo-curable transfer layer having excellent mold release properties and transfer property.

Although the content rate of a recurring unit of (meth)acrylate having an alicyclic group in the polymer is not restricted, the content rate preferably is in the range of 50 to 100% by weight, especially 60 to 90% by weight. Since the content rate of the recurring unit of (meth)acrylate having an alicyclic group based on all the photo-curable composition have an influence on the mold release properties of the photo-curable transfer layer, the content rate of the recurring unit of (meth)acrylate having an alicyclic group is preferably adjusted in the step for preparing this polymer.

Further, hydroxyalkyl (meth)acrylate whose hydroxyalkyl has 2 to 4 carbon atoms preferably include, for example, 2-hydroxyethyl methacrylate, hydroxypropyl methacrylate. The hydroxyalkyl (meth)acrylate generally is contained in an amount of 5 to 25% by weight, preferably 5 to 20% by weight as a recurring unit in the polymer.

The acrylic resin having a hydroxyl group may have as other monomers methyl methacrylate and/or alkyl (meth)acrylate whose alkyl has 2 to 10 carbon atoms. Examples of the alkyl (meth)acrylate whose alkyl has 2 to 10 carbon atoms (especially 3 to 5 carbon atoms) include ethyl (meth)acrylate, n-propyl (meth)acrylate, isopropyl (meth)acrylate, n-butyl (meth)acrylate, isobutyl (meth)acrylate, 2-ethylhexyl (meth)acrylate. The other monomers preferably include methyl methacrylate, n-butyl (meth)acrylate, isobutyl (meth)acrylate, 2-ethylhexyl (meth)acrylate, especially methyl methacrylate.

The acrylic resin preferably has number average molecular weight of not less than 90,000, especially 90,000 to 1,000,000, and weight average molecular weight of not less than 90,000, especially 90,000 to 300,000.

As the polymer of the invention, acrylic resin having both of a photopolymerizable functional group and a functional group containing an active hydrogen such as a hydroxyl group can be also used. Such reactive acrylic resin generally is a homopolymer or copolymer which has a photopolymerizable functional group and a functional group having active hydrogen in its main chain or side chain. Hence the homopolymer or copolymer can be obtained, for example, by copolymerizing (meth)acrylate monomer(s) comprising at least one (meth)acrylate having an alicyclic group as mentioned above with (meth)acrylate (e.g., 2-hydroxyethyl (meth)acrylate) having a functional group such as a hydroxyl group, and reacting the resultant polymer with a compound (e.g., isocyanatoalkyl (meth)acrylate) having a functional group capable of reacting with the active hydrogen-containing group of the polymer and having a photopolymerizable functional group. In the latter reaction, the amount of the compound (e.g., isocyanatoalkyl (meth)acrylate) having a functional group capable of reacting with the hydroxyl group is adjusted so as to leave the hydroxyl group. Thus, the polymer having the photopolymerizable functional group and the hydroxyl group as the active hydrogen-containing group can be obtained.

Otherwise, the use of (meth)acrylate (e.g., 2-aminoethyl (meth)acrylate) having an amino group instead of the hydroxyl group in the reaction results in a polymer having the photopolymerizable functional group and the amino group as the active hydrogen-containing group.

Similarly a polymer having the photopolymerizable functional group and a carboxyl group as the active hydrogen-containing group can be obtained.

In the invention, it is also preferred to use acrylic resin having a photopolymerizable group through urethane bond.

The acrylic resin having a photopolymerizable functional group has generally 1 to 50% by mole, preferably 5 to 30% by mole of the photopolymerizable functional group. Examples of the photopolymerizable functional group preferably include acryloyl, methacryloyl and vinyl groups, especially acryloyl and methacryloyl groups.

The photo-curable composition for forming the photo-curable transfer layer of the invention may comprise other polymers so long as the other polymers do not damage the effect of the invention. Examples of the other polymers include polyvinyl acetate, vinyl acetate/ (meth)acrylate copolymer, ethylene/vinyl acetate copolymer, polystyrene and copolymer thereof, polyvinyl chloride and copolymer thereof, butadiene/acrylonitrile copolymer, acrylonitrile/butadiene/styrene copolymer, methacrylate/acrylonitrile/butadiene/styrene copolymer, 2-chlorobutadiene-1,3-polymer, chlorinated rubber, styrene/butadiene/styrene copolymer, styrene/isoprene/styrene block copolymer, epoxy resin, polyamide, polyester, polyurethane, cellulose ester, cellulose ether, polycarbonate, polyvinyl acetal.

[Reactive diluent]

Examples of the reactive diluent (monomer and oligomer) having a photopolymerizable functional group, which is contained in the photo-curable composition, include,

(meth)acrylate monomers such as dimethyloltricyclodecane di(meth)acrylate, isobornyl (meth)acrylate, tricyclodecane mono(meth)acrylate, dicyclopentenyloxyethyl (meth)acrylate, 1,6-hexanediol di(meth)acrylate,

2-hydroxyethyl (meth)acrylate, 2-hydroxypropyl (meth)acrylate, 4-hydroxybutyl (meth)acrylate, 2-hydroxy-3-phenyloxypropyl (meth)acrylate, 2-ethylhexyl (meth)acrylate, 2-ethylhexylpolyethoxy (meth)acrylate, benzyl (meth)acrylate, phenyloxyethyl (meth)acrylate, tetrahydrofurfuryl (meth)acrylate, acryloylmorpholine, N-vinylcaprolactam, o-phenylphenyloxyethyl (meth)acrylate, 2-hydroxy-3-acryloyloxypropyl methacrylate,

neopentylglycol di(meth)acrylate, neopentyl glycol dipropoxy di(meth)acrylate, neopentyl glycol hydroxypivalate di(meth)acrylate, tricyclodecanedimethylol di(meth)acrylate, nonanediol di(meth)acrylate,

glycerol diacrylate, glycerol acrylate methacrylate, glycerol dimethacrylate, trimethylolpropane diacrylate, trimethylolpropane acrylate methacrylate, trimethylolpropane dimethacrylate,

trimethylolpropane tri(meth)acrylate, pentaerythritol tri(meth)acrylate, pentaerythritol tetra(meth)acrylate, tris[(meth)acryloxyethyl]isocyanurate and ditrimethylolpropane tetra(meth)acrylate; and
the following (meth)acrylate oligomer such as:

polyurethane (meth)acrylate such as compounds obtained by reaction of:

a polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1,3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol and polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol and ε-caprolactone; a compound obtained by reaction of a reaction product of the above-mentioned polyol and the above-mentioned polybasic acid or anhydride thereof and ε-caprolactone; polycarbonate polyol; or polymer polyol), and

an organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4'-trimethylhexamethylene diisocyanate), and

hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono (meth)acrylate, pentaerythritol tri(meth)acrylate or glycerol di(meth)acrylate);

bisphenol-type epoxy(meth)acrylate obtained by reaction of bisphenol-A epoxy resin or bisphenol-F epoxy resin and (meth)acrylic acid.

These compounds having photopolymerizable functional group can be employed singly or in combination of two or more kinds.

In the invention, the photo-curable transfer layer preferably contains a monomer having an alicyclic group that shows low polarity as the reactive diluent in order to further improve mold release properties of the photo-curable transfer layer. The preferred examples of the monomer having an alicyclic group include dimethyloltricyclodecane di(meth)acrylate, isobornyl (meth)acrylate, tricyclodecane mono(meth)acrylate, dicyclopentenyloxyethyl (meth)acrylate, especially dimethyloltricyclodecane di(meth)acrylate, isobornyl (meth)acrylate.

In the photo-curable composition of the invention, a ratio by weight of the polymer to the reactive diluent is preferably in the range of 20:80 to 80:20, especially in the range of 30:70 to 70:30.

[Transparent film]

In the invention, as the polymer film 12b of the transparent film 12, any polymer film may be used as long as it has transparency and physical properties required for the photo-curable transfer sheet of the invention. A polyester film is preferred. The polyester is generally linear saturated polyester derived from aromatic dibasic acid or ester-forming derivative thereof and diol or ester-forming derivative thereof.

Examples of the polyester include polyethylene terephthalate (PET), polyethylene-2,6-naphthalate, polyethylene isophthalate, polybutylene terephthalate, poly(1,4-cyclohexylenedimethylene terephthalate). Copolymers of these monomers or a blend of the copolymer with other resin as an accessory component (in amount of less than 50 mol%) can be also used. Of these polyesters, polyethylene terephthalate (PET) and polyethylene-2,6-naphthalate are preferred in view of balance between mechanical properties and optical properties. Particularly, polyethylene-2,6-naphthalate has increased mechanical strength, reduced heat shrinkage and reduced amount of oligomer generated on heating, and therefore is excellent compared with polyethylene terephthalate from these viewpoints.

The thickness of the polymer film 12b generally is in the range of 1 to 500$\mu$m, preferably 3 to 400$\mu$m, more preferably 6 to 300$\mu$m, particularly 12 to 250$\mu$m.

In the invention, though the transparent film 12 may not have the adhesion layer 12a, it is preferred to provide the adhesion layer 12a on the polymer film 12b in order to enhance adhesion between the polymer film 12b and the photo-curable transfer 11. The adhesion layer 12a preferably is a layer consisting of a polyester resin, a polyurethane resin, an acrylic resin or a mixture of two or more kinds thereof. A thickness of the adhesive layer 12a preferably is in the range of 0.01 to 0.3$\mu$m, especially 0.02 to 0.2$\mu$m.

[Method for forming concave-convex pattern]

Subsequently, the method for forming a fine concave-convex pattern of the invention carried out by using the above photo-curable transfer sheet 10 is explained with reference to the drawings. Generally, a nanoimprint method can be also carried out in the same manner as the method for forming a fine concave-convex pattern.

The schematic section views illustrating the representative embodiment of the method for forming a fine concave-convex pattern of the invention are shown in Figs. 2 and 3

First, the release sheet 13 is removed from the photo-curable transfer sheet 10, and consequently the photo-curable transfer layer 11 is exposed. The photo-curable transfer layer 11 is bonded and fixed onto an adhesive layer 12a of the transparent film 12 composed of the polymer film 12b and the adhesive layer 12a thereon. A stamper 14 as a mold is arranged on the photo-curable transfer layer 11 such that the fine concave-convex pattern of the stamper 14 faces the surface of the photo-curable transfer layer 11 (stage (a) of Fig. 2). Subsequently, the stamper 14 is depressed on the photo-curable transfer layer 11 to form a laminate composed of the stamper 14 and the photo-curable transfer layer 11 which adheres closely to the concave-convex pattern surface of the stamper 14 (stage (b) of Fig. 2). The stages (a) and (b) constitute the step (1). If necessary, the photo-curable transfer layer 11 is heated to facilitate the depression. In case the depression can be carried out at room temperature, the heating is unnecessary. Under this condition, the photo-curable transfer layer 11 is exposed to light (UV) to be cured (the step (2)). It is preferred that the exposure to light is carried out with the depression because of reduction of tact time. Then, the stamper 14 is removed (peeled) from the photo-curable transfer layer 11 c (stage (c) of Fig. 2). The stage (c) constitutes the step (3). In this way, the inverted fine concave-convex pattern is formed on the photo-curable transfer layer 11, the inverted fine concave-convex pattern being obtained by inverting the fine concave-convex pattern of the stamper.

In the method of the invention, the stamper 14 is much easily removed from the cured photo-curable transfer layer 11 c and a part of the cured transfer layer 11 is not stuck onto the stamper 14 because of using the photo-curable transfer sheet of the invention. Hence, it is possible to form the inverted fine concave-convex pattern having no defect without doing damage to the stamper 14.

In case the photo-curable transfer sheet 10 having the inverted fine concave-convex pattern, which is formed by the fine concave-convex pattern of the stamper 14 being inverted, is used as an intermediate stamper, a fine concave-convex pattern can be formed on a surface of a photo-curable resin layer 16 formed on a substrate 15.

A liquid photo-curable resin composition has been applied onto a surface of the substrate 15 and as a result, the photo-curable resin layer 16 has been formed. Examples of the substrate 15 include a substrate for electronic part, and one consisting of this substrate and a wiring pattern thereon. In more detail, the examples of the substrate include silicon wafer, metallic substrates such as copper, chromium, iron, aluminum, and a glass substrate.

The intermediate stamper 20 prepared above which consists of the transparent film 12 and the photo-curable transfer layer 11 c having the inverted fine concave-convex pattern formed thereon is arranged on the photo-curable resin layer 16 such that the inverted fine concave-convex pattern faces the surface of the photo-curable resin layer 16 (stage (d) of Fig. 3). Subsequently, the intermediate stamper 20 is depressed on the photo-curable resin layer 16 (stage (e) of Fig. 3). The stages (d) and (e) constitute the step (4). If necessary, the photo-curable resin layer 16 is heated to facilitate the depression. In case the depression can be carried out at room temperature, the heating is unnecessary. Under this condition, the photo-curable resin layer 16 is exposed to light (UV) to be cured (the step (5)). It is preferred that the exposure to light is carried out with the depression because of reduction of tact time. Then, the intermediate stamper 20 is removed (peeled) from the cured photo-curable resin layer 16 in which a fine concave-convex pattern is formed (stage (f) of Fig. 3). The stage (f) constitutes the step (6). In this way, the fine concave-convex pattern is formed on the cured photo-curable resin layer 16, the fine concave-convex pattern being the same as the concave-convex pattern of the stamper.

In the method of the invention, the intermediate stamper 20 is much easily peeled from the cured photo-curable resin layer 16 and a part of the cured photo-curable resin layer 16 is not stuck onto the intermediate stamper 20 because of using the photo-curable transfer sheet 10 of the invention for the intermediate stamper 20. Hence, it is possible to form the fine concave-convex pattern (which is the same as the concave-convex pattern of the stamper) having no defect on the cured photo-curable resin layer 16.

Though the photo-curable resin layer 16 may be formed from the photo-curable composition deformable by application of pressure, in the same manner as the photo-curable transfer sheet 10, a liquid photo-curable resin composition is preferably used for forming the photo-curable resin layer 16 because it can be applied in the form of thin layer onto the substrate 15. In the above-mentioned method, the photo-curable transfer sheet of the invention is particularly improved in the mold release properties from the photo-curable resin layer, and hence the use of the liquid photo-curable resin composition is effective.

Generally, the steps (1) to (6) are repeated to give photo-curable transfer layers having fine concave-convex pattern. However, a great number of photo-curable transfer layers can be also prepared by using the intermediate stamper 20. In more detail, after the steps (1) to (3) are carried out, the steps (4) to (6) can be repeated.

Though the above-mentioned method is explained using a stamper as the mold, it can be also carried out using other molds. A stamper used in a nanoimprint method is preferably used as the mold because it has an advantage in transfer of fine concave-convex pattern. Any can be used as material of the mold. Preferred are nickel, titanium, silicon, quartz, particularly nickel.

Fig. 4 shows a schematic section view illustrating a representative embodiment of a method for continuously forming a fine concave-convex pattern of the present invention. First, a continuous photo-curable transfer sheet 30 is delivered from a lead-on roll 36a, and a release sheet 33 is wound around a wind-up roll 36b through a guide roll 36c to be removed. A photo-curable transfer layer 31 which is bonded and fixed onto a transparent film 32 (comprising a polymer film and an adhesive layer thereon) is exposed, and transported in the direction of arrow through a guide roll 36d. When the photo-curable transfer sheet 30 comes at a UV- transmission type pressure bonding part 35 movable up and down provided with a UV lamp 37 and a stamper part 34 having a fine concave-convex pattern (i.e., between 34 and 35), it comes to a stop. At the same time of the stop, the UV- transmission type pressure bonding part 35 moves downward to push down the transparent film 32, whereas the photo-curable transfer layer 31 is depressed to the stamper part 34. After or on the depression, the photo-curable transfer layer 31 is exposed to light of the UV lamp 37 to be cured. Thereafter, the UV-transmission type pressure bonding part 35 moves upward, and at the same time the cured photo-curable transfer layer 31c is peeled from the stamper part 34. The photo-curable transfer layer 31c has a fine concave-convex pattern formed by inversion of the fine concave-convex pattern of the stamper part 34, and is used as an intermediate stamper.

The cured photo-curable transfer layer 31 c bonded and fixed onto the transparent film 32 is transported again. When it comes at a UV-transmission type pressure bonding part 45 movable up and down provided with and a UV lamp 47 and a substrate 40 having a photo-curable resin layer 41 (i.e., between 40 and 45), it comes to a stop. The photo-curable resin layer 41 has been formed by coating a liquid photo-curable resin composition. At the same time of the stop, the UV- transmission type pressure bonding part 45 moves downward to push down the transparent film 32, whereas the photo-curable transfer layer 31 c is pressed to the photo-curable resin layer 41. After or on the press, the photo-curable resin layer 41 is exposed to light of the UV lamp 47 to be cured. Thereafter, the UV- transmission type pressure bonding part 45 moves upward, and at the same time the cured photo-curable resin layer 41 is peeled from the photo-curable transfer layer 31c. The same fine concave-convex pattern as that of the stamper part 34 is formed on the surface of the photo-curable resin layer 41, which becomes a product. The cured photo-curable transfer layer 31 c bonded and fixed onto the transparent film 32 is used as an intermediate stamper, whereby a fine concave-convex pattern can be continuously formed on plural photo-curable resin layers by the process as above. Thereafter, the cured photo-curable transfer layer 31 c bonded and fixed onto the transparent film 32 is wound around a wind-up roll 36f through the guide roll 36e. The transfer of the stamper part 34 to the photo-curable transfer layer 31c and the transfer of the photo-curable transfer layer 31 c to the photo-curable resin layer 41 may not be carried out continuously. For example, the cured photo-curable transfer layer 31 c bonded and fixed onto the transparent film 32 may be wound around a wind-up roll 36f, and then at appropriate times, the pattern of the intermediate stamper may be transferred to the photo-curable resin layer 41 to prepare a product.

Other materials used for forming the cured photo-curable transfer sheet are explained below.

[Photopolymerization initiator]

Any known photopolymerization initiators can be used in the invention. The initiators having good storage-stability after mixing with other integrants are preferred. Examples of the photopolymerization initiators include acetophenone type initiators; benzoin type initiators such as benzylmethylketal; benzophenone type initiators; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone, 2-methyl-1-[4-(methylthio)phenyl]-2-morphorinopropane-1 and benzophenone. These photopolymerization initiators can be employed together with one or more kinds of a photopolymerization promoter such as a benzoic acid type compound (e.g., 4-dimethylaminobezoic acid) or a tertiary amine compound by mixing the initiator with the promoter in optional ratio. The initiator can be employed singly or in combination of two or more kinds. The initiator is preferably contained in the photo-curable composition (nonvolatile content) in the range of 0.1 to 20% by weight, especially 1 to 10% by weight.

Of the above-mentioned photopolymerizable initiators, examples of the acetophenone type initiator include 4-phenoxydichloroacetophenone, 4-t-butyldichloroacetophenone, 4-t-butyltrichloroacetophenone, diethoxyacetophenone, 2-hydroxy-2-methyl-1-phenylpropane-1-on, 1-(4-isopropylphenyl)-2-hidroxy-2-methylpropane-1-on, 1-(4-dodecylphenyl)-2-hydroxy-2-methylpropane-1-on, 4-(2-hydroxyethoxy)-phenyl(2-hydroxy-2-propyl)ketone, 1-hydroxycyclohexylphenylketone, 2-methyl-1-[4-(methylthio)phenyl]-2-morphorino-propane-1-on, and examples of the benzophenone type initiator include benzophenone, benzoylbenzoic acid, methyl benzoylbenzoate, 4-phenylbenzophenone, hydroxybenzophenone, 4-benzoyl-4'-methylphenylsulfide and 3,3'-dimethyl-4-methoxybenzophenone.

The acetophenone type initiators especially preferably are 2-hydroxy-2-methyl-1-phenylpropane-1-on, 1-hydroxycyclohexylphenylketone and 2-methyl-1-[4-(methylthio)phenyl]-2-morphorinopropane-1, and the benzophenone type initiators preferably are benzophenone, benzoylbenzoic acid and methyl benzoylbenzoate.

Preferred examples of the tertiary amine compounds of the photopolymerization promoter include triethanolamine, methyldiethanolamine, triisopropanolamine, 4,4'-dimethylaminobenzophenone, 4,4'-diethylaminobenzophenone, ethyl 2-dimethylaminobenzonate, ethyl 4-dimethylaminobenzonate, (n-butoxy)ethyl 4-dimethylaminobenzonate, isoamyl 4-dimethylaminobenzonate and 2-ethylhexyl 4-dimethylaminobenzonate. Especially preferred are ethyl 4-dimethylaminobenzonate, (n-butoxy)ethyl 4-dimethylaminobenzonate, isoamyl 4-dimethylaminobenzonate and 2-ethylhexyl 4-dimethylaminobenzonate.

[Diisocyanate]

Examples of diisocyanate usable in the photo-curable composition of the invention include tolylene diisocyanate (TDI), isophorone diisocyanate, xylylene diisocyanate, diphenylmethane-4,4'-diisocyanate, dicyclopentanyl diisocyanate, hexamethylene diisocyanate, 2,4,4-trimethylhexamethylene diisocyanate, 2,2,4-trimethylhexamethylene diisocyanate. Further three or more functional isocyanate compounds such as TDI adduct of trimethylol propane and hexamethylene diisocyanate adduct of trimethylol propane can be employed. Of these compounds, hexamethylene diisocyanate adduct of trimethylol propane is preferred.

The diisocyanate is preferably contained in the amount of 0.2 to 4% by weight, especially 0.2 to 2% by weight in the photo-curable composition (nonvolatile content), which results in appropriate crosslinking of the transfer layer to prevent the transfer layer from exudation with maintaining good transfer property between the transfer layer and the concavo-convex surface of the mold such as a stamper. The reaction of the diisocyanate with the polymer gradually progresses after the provision of the transfer layer, for example, progresses to a considerable degree at a room temperature (generally 25˚C) for 24 hours. Also it is considered that the polymer and diisocyanate in a coating solution for forming the transfer layer are slightly reacted with each other during the term from its preparation to its coating. Because it is preferred that the transfer layer is cured to some degree between the provision of the transfer layer and the rolling up of the resultant transfer layer, the curing of transfer layer may be promoted by heating during or after of the provision of the transfer layer, or before the rolling up.

[Others]

The photo-curable composition of the invention used for forming the photo-curable transfer layer preferably contains further, if desired, the following thermoplastic resin and other additives.

As other additives, a lubricant (mold release agent) can be used for further improving the mold release properties. Examples of the lubricant include phosphorous atom containing compounds such as alkyl polyoxyalkylene phosphate compounds, trialkyl phosphate compounds, phosphate salts and amide phosphate; silicone resin such as unmodified or modified polysiloxane; fluorine-atom-containing ethylenically unsaturated compounds such as fluoro(meth)acrylates. The lubricant is generally contained in the amount of 0.01 to 5 parts by weight based on 100 parts by weight of the above polymer (solid content).

Also, as other additives, a silane coupling agent (adhesion promoter) can be used. Examples of the silane coupling agent include vinyltriethoxysilane, vinyltris(β-methoxyethoxy)silane, γ-methacryloxypropylmethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropyltrimethoxysilane, γ-aminopropyltriethoxysilane, N-β-(aminoethyl)-γ-aminopropyltrimethoxysilane. The silane coupling agent can be used singly, or in combination of two or more kinds. The silane coupling agent is preferably used in the range of 0.01 to 5 weight by part based on 100 parts by weight of the above polymer (solid content).

Similarly, an epoxy group-containing compound can be used for enhancing the adhesive strength. Examples of the epoxy group-containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol glycidyl ether, p-tert-butylphenyl glycidyl ether, diglycidyl adipate, diglycidyl o-phthalate, glycidyl methacrylate and butyl glycidyl ether. Further, the similar effect is also obtained by using an oligomer having an epoxy group and molecular weight of hundreds to thousands, or a polymer having an epoxy group and weight average molecular weight of thousands to hundreds of thousands. The content of the compound having an epoxy group is sufficient in the range of 0.1 to 20 parts by weight based on 100 parts by weight of the reactive polymer (solid content). At least one of the compounds having an epoxy group can be used singly or in combination of two or more kinds.

Further, as other additives, a hydrocarbon resin can be further used for improving processing properties such as laminating properties. The hydrocarbon resin may be either natural resin or synthetic resin. Examples of the natural resins preferably include rosins, rosin derivatives and terpene resins. Examples of the rosins include gum resins, tall oil resins, wood resins. Examples of the rosin derivatives include hydrogenated rosins, disproportionated rosins, polymerized rosins, esterificated rosins, metal salts of rosins. Examples of the terpene resins include α-pinene resins, β-pinene resins, and terpene phenol resins. Moreover, as the natural resin, dammar, copal, shellac can be used. Examples of the synthetic resins preferably include petroleum resins, phenol resins, and xylene resins. Examples of the petroleum resins include aliphatic petroleum resins, aromatic petroleum resins, cycloaliphatic petroleum resins, copolymer type petroleum resins, hydrogenated petroleum resins, pure monomer type petroleum resins, and coumarone-indene resins. Examples of the phenol resins include alkylphenol resins and modified phenol resins. Examples of the xylene resins include xylene resins and modified xylene resins.

The resin such as the hydrocarbon polymer resin can be used in the amount of 1 to 20 parts by weight, preferably 5 to 15 parts by weight based on 100 parts by weight of the polymer (solid content) of the invention

The photo-curable composition may contain, in addition to the above-mentioned additives, an ultraviolet absorber, an aging resistant agent, a dye, and a processing auxiliary agent in a small amount. If desired, particles of silica gel or calcium carbonate may be contained in a small amount.

The photo-curable transfer layer of the invention generally has storage elastic modulus of not more than $1 \times 10^7$Pa which is determined under the conditions of frequency of 1Hz and a temperature of 25˚C, especially the storage elastic modulus of $1 \times 10^4$Pa to $6 \times 10^5$Pa. Further, the storage elastic modulus at 80˚C is preferably not more than $8 \times 10^4$Pa, especially $1 \times 10^4$Pa to $5 \times 10^5$Pa. Thereby, accurate and speedy transfer is ensured. Further, the photo-curable transfer layer of the invention generally has a glass transition temperature of not more than 20˚C. Thereby, in case the resultant photo-curable layer is pressed against a concave-convex surface of a stamper, the photo-curable layer follows accurately the uneven surface even at room temperature to have good flexibility. The photo-curable transfer layer especially has a glass transition temperature of 15˚C to -50˚C, further preferably 0˚C to -40˚C whereby the resultant photo-curable layer follows more accurately the concave-convex surface. When the glass transition temperature exceeds the upper limit, increased pressure and temperature are needed in the pressing and bonding steps of the sheet, which brings about lowering of workability. When the glass transition temperature falls to below the lower limit, the resultant cured sheet does not have sufficient hardness.

Further, the photo-curable transfer layer composed of the photo-curable composition is preferably configured such that the layer having been subjected to ultraviolet exposure of 300mJ/cm$^2$ has a glass transition temperature of not less than 65˚C. The brief exposure easily prevents of the variation of the concave shape by sagging, which is apt to occur due to residual stress generated in transferring, whereby the transferred shape of concave and the like can be maintained.

The photo-curable transfer sheet of the invention is generally prepared, for example, by homogeneously mixing the ingredients constituting the above-mentioned photo-curable composition, kneading the mixture by using an extruder or roll, and subjecting the kneaded mixture to a film-forming process using a calendar, roll, T-die extrusion or inflation to form a film of a predetermined shape. The photo-curable layer is generally formed on the adhesion layer of the transparent film. A more preferred process for forming the photo-curable transfer sheet comprises the steps of dissolving homogeneously the ingredients in a good solvent, applying the resultant solution onto a separator coated closely with silicone or fluoric resin by means of flow-coater method, roll-coater method, gravure-roll method, mayer-bar method or lip-die coating method, and vaporizing the solvent to form the photo-curable transfer layer.

The thickness of the photo-curable transfer sheet generally is in the range of 1 to 1,200μm, preferably 5 to 500μm, especially 5 to 300μm (preferably not more than 150μm). When the thickness is thinner than 1μm, sealing properties are lowered. When the thickness is thicker than 1,200μm, the thickness of the resultant molded product is so thick that trouble in housing or assembly of the molded product occurs.

The photo-curable transfer layer preferably has a thickness of 1 to 300μm, especially 3 to 100μm.

[Release sheet]

A release sheet can be provided on the photo-curable transfer layer of the photo-curable transfer sheet. The release sheet is generally composed chiefly of a plastic film and a release layer having low surface tension such as silicone provided thereon. The release layer comprises, for example, condensation reaction product of polysiloxane having hydroxy group and hydrogenated polysiloxane, or product formed from polysiloxane (preferably dimethyl polysiloxane) having unsaturated double-bond group (preferably vinyl group) and hydrogenated polysiloxane (preferably dimethyl polysiloxane).

The plastic film of the release sheet is a transparent resin film made mainly of an organic resin. Examples of the organic resin include polyester resin (e. g., polyethylene terephthalate, polycyclohexylene terephthalate, polyethylene naphthalate), polyamide (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed, especially polyethylene terephthalate employed. The thickness is generally in the range of 10 to 200μm, especially in the range of 30 to 100μm.

The photo-curable transfer layer has been preferably subjected to annealing treatment. The annealing treatment is preferably carried out by storing the layer at 30 to 100˚C, especially 40 to 70˚C, for 1 hour to 30 days, especially 10 hour to 10 days. The transfer sheet is preferably subjected to annealing treatment in the form of roll (in winding state). The annealing treatment promotes the movement of a component promoting release (mold release component) to the photo-curable transfer layer whereby it is considered that the stamper can be easily removed.

[Photo-curable resin composition]

Any photo-curable resin composition, in order to form a fine concave-convex pattern (product) by using the photo-curable transfer sheet of the invention as an intermediate stamper, can be used in the invention. Particularly, liquid compositions usable in a nanoimprint method are preferred. In the liquid compositions, the viscosity is preferably in the range of 10 to 10,000cps. The photo-curable resin composition comprises preferably a photo-curable resin and a photopolymerization initiator.

Examples of the photo-curable resin include urethane acrylate, polyester acrylate, epoxy acrylate, imide-based oligomer, polyene-thiol-based oligomer.

The urethane acrylate is obtained, for example, by reacting between a diisocyanate such as hexamethylene diisocyanate, isophorone diisocyanate, methylene bis(4-cyclohexyl isocyanate), trimethylhexamethylene diisocyanate, tolylene diisocyanate, 4,4-diphenylmethane diisocyanate, xylylene diisocyanate; and a polyol such as poly(propylene oxide)diol, poly(propylene oxide)triol, poly(tetramethylene oxide)diol, ethoxylated bisphenol A; and a hydroxyalkyl (meth) acrylate such as 2-hydroxyethyl acrylate, 2-hydroxyethyl methacrylate, 2-hydroxypropyl acrylate, glycidol dimethacrylate, pentaerythritol acrylate. The urethane acrylate has an acryloyl group and a urethane bond in its molecule.

Examples of the polyester acrylate include polyester acrylate made of phthalic anhydride, propylene oxide and acrylic acid, one made of adipic acid, 1,6-hexane diol and acrylic acid, and one made of trimellitic acid, diethylene glycol and acrylic acid.

The epoxy acrylate is generally synthesized by the reaction an epoxy compound such as epichlorohydrin with acrylic acid or methacrylic acid. The examples include bisphenol-A epoxy acrylate synthesized by the reaction of bisphenol-A epoxy resin, epichlorohydrin and acrylic acid, bisphenol-S epoxy acrylate synthesized by the reaction of bisphenol-S epoxy resin, epichlorohydrin and acrylic acid, bisphenol-F epoxy acrylate synthesized by the reaction of bisphenol-F epoxy resin, epichlorohydrin and acrylic acid, and phenol novolac epoxy acrylate synthesized by the reaction of phenol novolac, epichlorohydrin and acrylic acid.

Examples of the epoxy resin include bisphenol epoxy resins such as bisphenol-A epoxy resin, bisphenol-F epoxy resin, bisphenol-AD epoxy resin, bisphenol-S epoxy resin; novolac epoxy resins such as phenol novolac epoxy resin and cresol novolac epoxy resin; aromatic epoxy resins such as trisphenol methane triglycidyl ether; and hydrogenerated product or bromide thereof.

The photopolymerization initiator (G) is preferably a photo-radical polymerization initiator and a photo-cationic polymerization initiator. Examples of a photo-radical-polymerization initiator include acetophenone derivatives such as 4-(2-hydroxyethoxy)phenyl(2-hydroxy-2-propyl)ketone, α-hydroxy-α, α'-dimethylacetophenone, methoxyacetophenone and 2,2-dimethoxy-2-phenylacetophenone; benzoin ether compounds such as benzoin ethyl ether and benzoin propyl ether; ketal derivatives such as benzyl dimethyl ketal; halogenated ketone, acyl phosphin oxide, acyl phosphonate, 2-methyl-1-[4-(methylthio)phenyl]-2-morphorinopropane-1-on, 2-benzyl-2-N,N-dimethylamino-1-(4-morphotinophenyl)-1-butanone, bis(2,4,6-trimethylbenzoyl)-phenylphosphinoxidebis-(2,6-dimethoxybenzo yl)-2,4,4-trimethylpentylphosphinoxide, bis(η5-cyclopentadienyl)-bis(pentafluorophenyl)-titanium, bis(η5-cyclopentadienyl)-bis[2,6-difluoro-3-(1H-pyrr-1-yl)phenyl]-titanim, anthracene, perylene, coronene, tetracene, benzanthracene, phenothiazine, flavin, acridine, ketocoumalin, thioxanthone derivatives, benzophenone, acetophenone, 2-chlorothioxanthone, 2,4-dimethylthioxanthone, 2,4-diethylthioxanthone, 2,4-dipropylthioxanthone, and isopropylthioxanthone. Examples of a photo-cationic-polymerization initiator include iron-allene complexes, aromatic diazonium salts, aromatic iodonium salts, aromatic sulfonium salts, onium salts, pyridinium salts, aluminum complexes/silanol salts, trichloromethyl triazine derivatives. Examples of counter anions of the onium salts or pyridinium salts include $SbF_6^-$, $PF_6^-$, $AsF_6^-$, $BF_4^-$, tetrakis(pentafluoro)borate, trifluoromethane sulfonate, methane sulfonate, trifluoro acetate, acetate, sulfonate, tosylate, nitrate.

The additive amount of the photopolymerization initiator (G) generally is in the range of 0.1 to 15 parts by weight, preferably 0.5 to 10 parts by weight, based on 100 parts by weight of the photo-curable resin.

The photo-curable resin composition may contain a reactive diluent. Examples of the reactive diluent include 1,4-butane diol diacrylate, 1,6-hexane diol diacrylate, neopentyl glycol diacrylate, 2-(2-ethoxyethoxy)ethyl acrylate, tetrahydorofurfuryl acrylate, 2-phenoxyethyl acrylate, diethylene glycol diacrylate, tetraethylene glycol diacrylate, 1,3-butylene glycol diacrylate, tripropylene glycol diacrylate, trimethylolpropane triacrylate, pentaerythritol tetraacrylate, hydoxypivalic acid neopentyl glycol diacrylate.

The photo-curable resin composition of the invention may contain further, if desired, known photopolymerization initiators, thermal polymerization inhibitors, fillers, tackifiers, thixotropy imparting agents, rization inhibitors, fillers, tackifiers, thixotropy imparting agents, plasticizers, colorants.

In case the photo-curable transfer sheet and the photo-curable resin layer of the invention is cured, it is possible to adopt, as light source used, various sources generating light in the wavelength range of from ultraviolet to visible rays. Examples of the sources include a super-high-pressure lamp, a high-pressure lamp, a low-pressure mercury lamp, a chemical lamp, a xenon lamp, a halogen lamp, a mercury halogen lamp, a carbon arc lamp, and an incandescent electric lamp, and laser beam. The exposing time is generally in the range of 0.1 second to dozens seconds, preferably 0.5 second to a few seconds, depending upon kinds of the lamp and strength of light. The amount of the ultraviolet exposure preferably is not less than 300mJ/$cm^2$.

To promote the curing, the laminate may be heated beforehand for 30 to 80˚C, and then the heated laminate may be exposed to ultraviolet rays.

The invention is illustrated in detail using the following Examples.

EXAMPLE

(1) Preparation of photo-curable composition

Monomers having composition ratio (molar ratio) shown in Table 1 were polymerized by known method to prepare polymers 1 to 6 having weight average molecular weight (Mw) and "alicyclic group containing monomer unit content rate P" = ("weight of alicyclic group containing monomer" / "total weight of all monomers") $\times 100(\%)$ shown in Table 1. As monomers having an alicyclic group, isobornyl methacrylate (monomer C), cyclohexyl methacrylate (monomer D) and tetrahydrofurfuryl methacrylate (monomer E) were used.

[Table 1]

| Mixture ratio (molar ratio) | Polymer 1 | Polymer 2 | Polymer 3 | Polymer 4 | Polymer 5 | Polymer 6 |
|---|---|---|---|---|---|---|
| Monomer A[*1] | 6 | 5 | 3 | 1 | 3 | 3 |
| Monomer B[*2] | 3 | -- | -- | -- | -- | -- |
| Monomer C[*3] | -- | 4 | 6 | 8 | -- | -- |
| Monomer D[*4] | -- | -- | -- | -- | 6 | -- |
| Monomer E[*5] | -- | -- | -- | -- | -- | 6 |
| Monomer F[*6] | 1 | 1 | 1 | 1 | 1 | 1 |
| Weight average molecular weight (Mw) | 110,000 | 90,000 | 90,000 | 90,000 | 90,000 | 90,000 |
| Alicyclic group containing monomer unit content rate **P**[*6] (%) | 0 | 58 | 76 | 89 | 70 | 70 |
| Note)<br>[*1]: Methyl methacrylate [*2]: Butyl methacrylate<br>[*3]: Isobornyl methacrylate [*4]: Cyclohexyl methacrylate<br>[*5]: Tetrahydrofurfuryl methacrylate<br>[*6]: 2-Hydroxyethyl methacrylate<br>[*7]: "alicyclic group containing monomer unit content rate P" = ("weight of alicyclic group containing monomer" / "total weight of all monomers") $\times$ 100(%) | | | | | | |

(2) Preparation of photo-curable transfer sheet (Examples 1 to 9, and Comparison Examples 1 to 2)

Photo-curable transfer sheets of Examples 1 to 9 and Comparison Examples 1 to 2 were prepared by using photo-curable compositions shown in Table 2.
[Table 2]

(Photo-curable composition of photo-curable transfer layer)

| | Trade name | Example 1 | Example 2 | Example 3 | Example 4 | Example 5 | Example 6 | Example 7 | Example 8 | Example 9 | Co. Ex. 1 | Co. Ex. 2 |
|---|---|---|---|---|---|---|---|---|---|---|---|---|
| Polymer | Polymer-1 | -- | -- | -- | -- | -- | -- | -- | -- | -- | 100 | 100 |
| | Polymer-2 | -- | -- | -- | -- | -- | -- | --- | 100 | -- | -- | -- |
| | Polymer-3 | 100 | 100 | 100 | -- | -- | 100 | 100 | -- | -- | -- | -- |
| | Polymer-4 | -- | -- | -- | -- | -- | -- | -- | -- | 100 | -- | -- |
| | Polymer-5 | -- | -- | -- | 100 | --- | -- | -- | -- | -- | -- | -- |
| | Polymer-6 | -- | -- | -- | -- | 100 | -- | -- | --- | -- | -- | -- |
| Monomer | SR238F[*8] | -- | 100 | 100 | 100 | 100 | 70 | 130 | 100 | 100 | 100 | -- |
| | DCP-A[*9] | 100 | -- | -- | -- | -- | -- | -- | -- | -- | -- | 100 |
| Photo initiator | Irgacure 651 | 2.0 | 2.0 | 2.0 | 2.0 | 2.0 | 1.7 | 2.3 | 2.0 | 2.0 | 2.0 | 2.0 |
| Hardener | BXX5627 | 1.5 | 1.5 | 1.5 | 1.5 | 1.5 | 1.3 | 1.7 | 1.5 | 1.5 | 1.5 | 1.5 |
| Inhibitor | MEHQ | 0.05 | 0.05 | 0.05 | 0.05 | 0.05 | 0.05 | 0.05 | 0.05 | 0.05 | 0.05 | 0.05 |
| Inner lubricant | UV3500 | 2.0 | 2.0 | 2.0 | 2.0 | 2.0 | 1.7 | 2.3 | 2.0 | 2.0 | 2.0 | 2.0 |
| | LTP-2 | -- | -- | 0.1 | -- | -- | -- | -- | -- | -- | -- | -- |
| Alicyclic group containing monomer unit content rate **T**[*10] | | 37.0 | 37.0 | 37.0 | 34.1 | 34.1 | 43.5 | 32.2 | 28.2 | 43.3 | 0 | 0 |

Note) [*8]: 1,6-hexane diol diacrylate (Sartomer); [*9]: Dimethyloltricyclodecane diacrylate (KYOEISHA CHEMICAL Co.,LTD); Irgacure 651 (Chi-ba-Speciality-Chemicals); BXX5627 (Toyo Ink Mfg.); MEHQ (Kawaguchi Chemical Industry Co., LTD.); UV3500 (BYK-Chemie GmbH); LTP-2 (Kawaken Fine Chemicals Co.,Ltd.); "alicyclic group containing monomer unit content rate T" = ((("alicyclic group containing monomer unit content rate P"/100) × "weight of alicyclic group containing polymer") / "total weight of photo-curable composition") × 100(%)

In more detail, each of the photo-curable compositions was homogeneously dissolved and kneaded to give a mixture, which was applied onto a whole surface of a transparent film (Trade name: HPE, width: 300mm, length: 300m, thickness: 75μm; available from Teijin DuPont Films Japan Limited) and dried to form a photo-curable transfer layer of thickness of 25μm. Subsequently, a release sheet (Trade name: A31, width: 300mm, length: 300m, thickness: 50μm; available from Teijin DuPont Films Japan Limited) was attached to the opposite side of the photo-curable transfer layer to be rolled up in the form of roll. Thus, a full-edge type roll of photo-curable transfer sheet of diameter of 260mm was prepared. The transparent film is composed of a PET film (75μm) and an adhesion layer (a mixture of polyester and acrylic resin, thickness: 0.2μm) thereon. The "alicyclic group containing monomer unit content rate T" = ((("alicyclic group containing monomer unit content rate P"/100) × "weight of alicyclic group containing polymer") / "total weight of photo-curable composition") × 100(%) of each of the photo-curable transfer layers is shown in Table 2.

(3) Test for forming concave-convex pattern

A process for forming a concave-convex pattern shown in Fig. 4 was performed by using the photo-curable transfer sheets of Examples 1-9 and Comparison Examples 1-2. In more detail, a fine concave-convex pattern was formed on each of two kinds of photo-curable resin layers, one being composed of a liquid photo-curable resin composition (Resin for UV-nanoimprint: PAK-1, available from Toyo Gosei Co., Ltd.) and the other being composed of a liquid photo-curable resin composition (photo-curable resin composition: TMP -1 (TMP-1 available from KYOEISHA CHEMICAL Co., LTD, and Irgacure 651 which are mixed at ratio of 99:1), which formed on a silicon substrate, by using a stamper made of nickel having a fine concave-convex pattern (Shape of pattern: depth of 50nm, height of 50nm, shape of rib) and using each of the photo-curable transfer sheets as an intermediate stamper.
The forming (molding) was carried out under the following conditions.
(Conditions for transferring to intermediate stamper)

Molding equipment: press plate (0.5MPa × 5 sec.)
UV exposure: 300mJ/cm$^2$ × 10 sec.
Mold pattern: 20mm squares

(Conditions for transferring to photo-curable resin layer)

Formation of liquid photo-curable resin composition: spin coater
Molding equipment: roll laminator
UV exposure: 350mJ/cm$^2$ × 3sec.
Mold pattern: 20mm squares

(4) Evaluation method

(Evaluation on transferring property to intermediate stamper)

(i) Mold release properties

After the transferring and molding, the resultant photo-curable transfer sheet is pulled up in the condition of 90 degree peeling test, and evaluated below.

O : There is no visual defect caused by peeling in plane and the peeling strength is not more than 10gf/25mm.
Δ: There is no visual defect caused by peeling in plane and the peeling strength is more than 10gf/25mm.
×: There is visual defect caused by peeling in plane.

(ii) Transferring property

The vertical broken-out sections of the concave-convex patterns of the intermediate stampers of which peeling properties were evaluated as Δ or O above are observed by a scanning electron microscope (SEM) at 20,000-fold magnification, and evaluated below.

O : The depths in all places of the transferred concave-convex pattern are more than 450nm.
Δ: The depths in some places of the transferred concave-convex pattern re are in the range of 400 to 450nm.

×: The depths in some places of the transferred concave-convex pattern are less than 400nm.

(iii) Workability

Workability of peeling a release sheet from a photo-curable transfer sheet is evaluated as below.

O : The release sheet can be peeled without damaging a surface appearance of the release sheet.
Δ: Though there is no migration of the photo-curable transfer sheet to the release sheet, poor appearance such as stripe or rolling occurs on the surface of the release sheet.
×: Migration of the photo-curable transfer sheet to the release sheet occurs, and the variation of the thickness and the phenomenon of pulling a string are generated.

(Evaluation on transferring property to photo-curable resin layer

(i) Mold release properties

Evaluation on each of photo-curable resin layers

After the transferring and molding, the resultant photo-curable transfer sheet is pulled up in the condition of 90 degree peeling test, and evaluated below as to two kinds of photo-curable resin layer.

O: There is no visual defect caused by peeling in plane and peeling strength is not more than 10gf/25mm.
Δ: There is no visual defect caused by peeling in plane and peeling strength is more than 10gf/25mm.
×: There is visual defect caused by peeling in plane.
Comprehensive evaluation
◎: Both evaluations on the two kinds of photo-curable resin layer are O.
O: Evaluation on one photo-curable resin layer is O whereas evaluation on the other photo-curable resin layer is Δ.
Δ: Evaluation on one photo-curable resin layer is O whereas evaluation on the other photo-curable resin layer is ×.
Δ: Both evaluations on the two kinds of photo-curable resin layer are Δ.
×: Both evaluations on the two kinds of photo-curable resin layer are ×.

(ii) Transferring property

The vertical broken-out sections of the concave-convex patterns of the photo-curable resin layers of which peeling properties were evaluated as Δ or ○ above are observed by a scanning electron microscope (SEM) at 20,000-fold magnification, and evaluated below.

O : The depths in all places of the transferred concave-convex pattern are more than 450nm.
Δ: The depths in some places of the transferred concave-convex pattern re are in the range of 400 to 450nm.
X: The depths in some places of the transferred concave-convex pattern are less than 400nm.

(5) Evaluation result

The evaluation result is shown in Table 3.
[Table 3]

| (Evaluation result on photo-curable sheet) | | | Ex. 1 | Ex. 2 | Ex. 3 | Ex. 4 | Ex. 5 | Ex. 6 | Ex. 7 | Ex. 8 | Ex. 9 | Co. Ex. 1 | Co. Ex. 2 |
|---|---|---|---|---|---|---|---|---|---|---|---|---|---|
| Monomer having alicyclic group used in polymer | | | Monomer C[*3] | Monomer C[*3] | Monomer C[*3] | Monomer D[*4] | Monomer E[*5] | Monomer C[*3] | Monomer C[*3] | Monomer C[*3] | Monomer C[*3] | -- | -- |
| Alicyclic group containing monomer unit content rate T[*10] (%) | | | 37.0 | 37.0 | 37.0 | 34.1 | 34.1 | 43.5 | 32.2 | 28.2 | 43.3 | 0 | 0 |
| Transferring property to intermediate stamper | Mold release properties | | O | O | O | O | O | ○ | O | O | O | O | O |
| | Transferring property | | O | O | O | O | O | Δ | Δ | O | O | O | O |
| | Workability | | O | O | O | O | ○ | O | Δ | O | Δ | O | O |
| Transferring property to photo-curable resin layer | Mold release properties | PAK-1[*11] | O | O | O | O | ○ | O | O | O | O | × | X |
| | | TMP-A[*12] | O | O | O | Δ | X | ○ | O | × | O | X | X |
| | | Comprehensive evaluation | ◎ | ◎ | ◎ | O | Δ | ◎ | ◎ | Δ | ◎ | x | X |
| | Transferring property | Pay-1[*11] | O | O | O | O | O | O | O | O | O | -- | -- |
| | | TMP-A[*12] | O | O | O | Δ | -- | O | O | -- | O | -- | -- |
| Note) *3-5: the same as in Table 1; *10: the same as in Table 2; *11: UV-nanoimprint: PAK-I, available from Toyo Gosei Co., Ltd;. *12: Photo-curable resin composition: TMP -1 (TMP-1 available from KYOEISHA CHEMICAL Co., LTD, and Irgacure 651 which are mixed at ratio of 99:1). | | | | | | | | | | | | | |

In Examples 1 to 9 using the photo-curable composition containing the polymers 2 to 6 having a recurring unit of (meth)acrylate having an alicyclic group, the mold release properties and transferring property between the mold and intermediate stamper, and the mold release properties (comprehensive evaluation) and transferring property between the intermediate stamper and photo-curable resin layer are evaluated to be "Δ" or more highly than "Δ". In contrast, in Comparison Examples 1 to 2 using the photo-curable composition containing no polymer having a recurring unit of (meth)acrylate having an alicyclic group, the mold release properties and transferring property between the mold and intermediate stamper are good and the mold release properties between the intermediate stamper and photo-curable resin layer are no good. Though Comparison Example 2 uses the reactive diluent having an alicyclic group, effect enhancing the mold release properties cannot be confirmed.

By comparison between Examples 1 to 5 having comparable "alicyclic group containing monomer unit content rate **T**", Examples 1 to 4 using polymers having a recurring unit of (meth)acrylate having an alicyclic hydrocarbon group (isobornyl group, cyclohexyl group) as an alicyclic group show excellent mold release properties. Compared with Example 8 using the photo-curable composition having "alicyclic group containing monomer unit content rate **T**" of 28.2% by weight, Examples 1 to 4, 6, 7 and 9 show excellent mold release properties, which shows that the use of the photo-curable compositions having "alicyclic group containing monomer unit content rate **T**" of 32 to 44% by weight brings about excellent mold release properties. mold release properties.

The present invention is not restricted to the above-mentioned embodiments and Examples, and can be modified variously within the gist of the invention.

Explanation of reference numbers

**[0117]**

| | |
|---|---|
| 10, 30: | Photo-curable transfer sheet |
| 11, 31: | Photo-curable transfer layer |
| 11c, 31c: | Photo-curable transfer layer (after curing) |
| 12, 32: | Transparent film |
| 12a: | Adhesion layer |
| 12b: | Polymer film |
| 13, 33: | Release sheet |
| 14: | Stamper |
| 15, 40: | Substrate |
| 16, 41: | Photo-curable resin layer |
| 20: | Intermediate stamper |
| 34: | Stamper part |
| 35, 45: | UV- transmission type pressure bonding part |
| 36a: | Lead-on roll |
| 36b, 36f: | Wind-up roll |
| 36c, 36d, 36e: | Guide roll |
| 37, 47: | UV lamp |

**Claims**

1. A photo-curable transfer sheet having a photo-curable transfer layer composed of a photo-curable composition deformable by application of pressure which comprises a polymer and a reactive diluent having a photopolymerizable functional group,
   wherein the polymer is an acrylic resin comprising a recurring unit derived from (meth)acrylate having an alicyclic group.

2. A photo-curable transfer sheet as defined in claim 1, wherein the recurring unit of (meth)acrylate having an alicyclic group is a recurring unit derived from (meth)acrylate having an isobornyl group and/or a cyclohexyl group.

3. A photo-curable transfer sheet as defined in claim 1 or 2, wherein the recurring unit of (meth)acrylate having an alicyclic group is contained in 32 to 44% by weight based on dry mass of photo-curable composition.

4. A photo-curable transfer sheet as defined in any of claims 1 to 3, wherein the reactive diluent comprises a monomer having an alicyclic group.

5. A photo-curable transfer sheet as defined in claim 4, wherein the alicyclic group of the monomer having an alicyclic group is a dimethyloltricyclodecane group or an isobornyl group

6. A method for forming a concave-convex pattern comprising of the steps (1) to (3):

   a step (1) of placing a mold having a fine concave-convex pattern surface thereon on the photo-curable transfer layer of the photo-curable transfer sheet as defined in any of claims 1 to 5, such that the concave-convex pattern surface of the mold is in contact with a surface of the photo-curable transfer layer, and depressing the mold and the photo-curable transfer sheet to form a laminate in which one surface of the photo-curable transfer layer adheres closely to the concave-convex pattern surface;
   a step (2) of exposing the photo-curable transfer layer of the laminate having the mold to ultraviolet rays to cure the photo-curable transfer layer, and
   a step (3) of removing the mold from the laminate to form an inverted pattern of the fine concave-convex pattern on a surface of the photo-curable transfer layer.

7. A method for forming a concave-convex pattern comprising of the steps (4) to (6):

   a step (4) of placing the photo-curable transfer sheet having the inverted pattern of the fine concave-convex pattern obtained by the method as defined in claim 6, which is referred to as an intermediate stamper, on a photo-curable resin layer consisting of a photo-curable resin composition formed on a substrate, such that the inverted concave-convex pattern surface of the intermediate stamper is in contact with a surface of the photo-curable resin layer and depressing the intermediate stamper and the photo-curable resin layer having the substrate to form a laminate in which the surface of the photo-curable resin layer adheres closely to the inverted concave-convex pattern surface; and
   a step (5) of exposing the photo-curable resin layer of the laminate having the intermediate stamper to ultraviolet rays to cure the photo-curable resin layer, and
   a step (6) of removing the intermediate stamper from the laminate to form a fine concave-convex pattern on a surface of the photo-curable resin layer, the fine concave-convex pattern being the same as that of the mold.

8. A method for forming a concave-convex pattern as defined in claim 7, wherein the photo-curable resin composition is in the form of liquid.

9. A method for forming a concave-convex pattern as defined in any of claims 6 to 8, wherein the mold is a stamper.

Fig. 1

Fig. 2

(a)

(b)

UV Radiation

(c)

Fig. 3

(d)

(e)

U V Radiation

(f)

Fig. 4

EP 2 479 779 A1

| | | |
|---|---|---|
| **INTERNATIONAL SEARCH REPORT** | | International application No. |
| | | PCT/JP2010/066020 |

**A. CLASSIFICATION OF SUBJECT MATTER**
*H01L21/027*(2006.01)i, *B29C33/38*(2006.01)i, *B29C59/02*(2006.01)i, *B32B3/26*(2006.01)i, *B32B27/30*(2006.01)i, *B29K33/04*(2006.01)n, *B32B3/30*(2006.01)n

According to International Patent Classification (IPC) or to both national classification and IPC

**B. FIELDS SEARCHED**

Minimum documentation searched (classification system followed by classification symbols)
H01L21/027, B29C33/38, B29C59/02, B32B3/26, B32B27/30, B29K33/04, B32B3/30

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2008-044237 A (Bridgestone Corp.),<br>28 February 2008 (28.02.2008),<br>paragraphs [0009], [0091] to [0100], [0111],<br>[0122], [0123]; fig. 2, 3<br>(Family: none) | 1-6,9<br>7,8 |
| X<br>A | JP 2008-143104 A (Bridgestone Corp.),<br>26 June 2008 (26.06.2008),<br>paragraphs [0045] to [0054], [0059], [0061],<br>[0071], [0081], [0082]; fig. 3<br>(Family: none) | 1-5<br>6-9 |

| | | |
|---|---|---|
| ☒ Further documents are listed in the continuation of Box C. | | ☐ See patent family annex. |

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>    13 October, 2010 (13.10.10) | Date of mailing of the international search report<br>    26 October, 2010 (26.10.10) |
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/066020 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y<br>A | JP 2005-515617 A (Brewer Science, Inc.),<br>26 May 2005 (26.05.2005),<br>paragraphs [0022] to [0043]; fig. 1, 2<br>& US 2003/0071016 A1    & US 2005/0167894 A1<br>& EP 1441868 A        & WO 2003/031096 A2<br>& CA 2462347 A        & TW 578200 B<br>& KR 10-2005-0035134 A | 7,8<br>1-6,9 |
| Y<br>A | JP 2007-186570 A (Hitachi Chemical Co., Ltd.),<br>26 July 2007 (26.07.2007),<br>entire text; all drawings<br>& US 2007/0160937 A1    & EP 1808447 A1<br>& CN 101000462 A | 8<br>1-7,9 |
| Y<br>A | JP 05-140254 A (Dainippon Ink And Chemicals,<br>Inc.),<br>08 June 1993 (08.06.1993),<br>entire text; all drawings<br>(Family: none) | 8<br>1-7,9 |
| A | JP 2007-165812 A (Obducat, AB.),<br>28 June 2007 (28.06.2007),<br>entire text; all drawings<br>& US 2007/0134362 A1    & EP 1795497 A1<br>& CN 1979336 A        & KR 10-2007-0061061 A<br>& SG 133485 A | 1-9 |
| A | JP 2007-131698 A (Mitsubishi Chemical Corp.),<br>31 May 2007 (31.05.2007),<br>entire text; all drawings<br>& US 2008/0102262 A1    & WO 2006/049296 A1 | 1-9 |
| A | JP 2007-291339 A (Bridgestone Corp.),<br>08 November 2007 (08.11.2007),<br>entire text; all drawings<br>(Family: none) | 1-9 |
| A | JP 10-307201 A (Toppan Printing Co., Ltd.),<br>17 November 1998 (17.11.1998),<br>entire text; all drawings<br>(Family: none) | 1-9 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007165812 A

- JP 2007291339 A